# EUROPEAN PATENT SPECIFICATION

(11) **EP 0 917 216 B1**
(45) Date of publication and mention of the grant of the patent: **24.03.2010**
(21) Application number: 98306710.9
(22) Date of filing: 21.08.1998
(51) Int. Cl.: H01L 51/50

(54) **Organic electroluminescent device with improved long-term stability**
Organische elektrolumineszente Vorrichtung mit verbesserter Langzeitstabilität
Dispositif organique électroluminescent avec stabilité à long terme améliorée

(30) Priority: 17.11.1997 KR 9760534; 20.05.1998 KR 9818193
(43) Date of publication of application: 19.05.1999
(73) Proprietor: LG Electronics, Inc., Seoul (KR)
(72) Inventor: Yoon, Jong Geun, Youngdungpo-ku, Seoul (KR); Kim, Myung Seop, Kwachun-si, Kyungki-do (KR); Oh, Hyoung Yun, Dongjak-ku, Seoul (KR); Kim, Sung Tae, Eungpyung-ku, Seoul (KR)
(74) Representative: Palmer, Jonathan R.

(56) References cited:
- EP-A- 0 704 915
- US-A- 5 458 977
- US-A- 5 677 572

## Description

### BACKGROUND OF THE INVENTION

### Field of the Invention

The present invention relates to a display, and more particularly, to an organic electroluminescent (EL) device.

### Discussion of the Related Art

Organic EL devices, also called organic light emitting diodes (LEDs), are becoming very popular because of their possible application to flat panel displays (FPDs). They are extremely thin, matrix-addressable and operable at a relatively low voltage, typically less than 15 volts. Furthermore, they have additional features suitable for next generation FPDs such as, among other things, little dependence on viewing angle and good device-formability on flexible substrates. Organic LEDs differ fundamentally from conventional inorganic LEDs. While the charge transfer in inorganics is band-like in nature and the electron-hole recombination results in the interband emission of light, organic films are generally characterized by the low-mobility activated hopping transport and the emission is excitonic. Organic EL devices are also substantially different from conventional inorganic EL devices, especially in that organic EI devices are operable at low DC voltages.

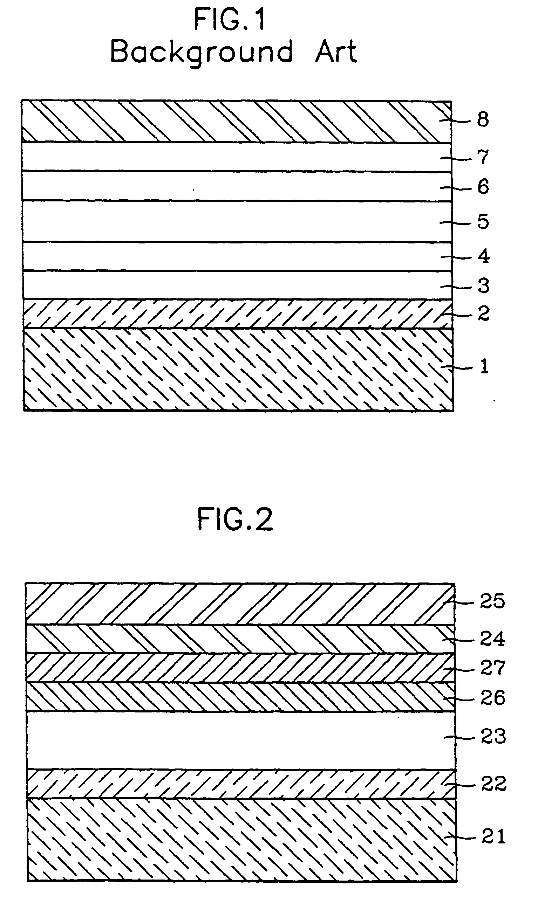

Referring to Fig. 1, a typical organic EL device is provided with an anode 2 formed on a transparent substrate 1, a hole injecting layer (HIL) 3 and a hole transporting layer (HTL) 4 formed on the anode 2, a luminescent layer 5 formed on the HTL 4, an electron transporting layer (ETL) 6 and an electron injecting layer (EIL) 7 formed on the luminescent layer 5, and a cathode 8 formed on the EIL 7. Any one or more of HIL, HTL, EIL and ETL may be omitted, depending on the device structure adopted.

Electrons and holes injected into the luminescent layer through the cathode 8 and the anode 2, respectively, recombine to decay radiatively. For most organic EL devices, the charge injection barrier is higher for electrons than for holes. It is well known that the electron injection barrier may be lowered by employing a low work function material for a cathode. But low work function materials are chemically reactive, which makes it difficult to use them for electrodes. Accordingly, the materials are often used as a cathode after being alloyed with one of more stable materials, as seen in the examples of Mg:Ag and Al:Li. However, the alloyed cathodes are still less stable, more costly to form, and more difficult to deposit in a uniform film, compared to aluminum. Even more serious problem often encountered with an alloyed cathode of Mg:Ag or Al:Li is frequent occurrence of cross talk or leakage current between pixels, which may be attributed to the diffusion of Mg or Li ions across organic layers. The problem can be much alleviated if one selects aluminum as a cathode material, but then one needs to find a way to improve its poor electron injecting capability. The electron injecting capability of a high work function cathode such as aluminum can be significantly enhanced by inserting a very thin layer (typically 0.3 nm~1.0 nm) of an electrically insulating material such as LiF, MgF₂ or Li₂O either between an aluminum electrode and the luminescent layer or between the aluminum electrode and ETL [IEEE Transactions on Electronic Devices, Vol. 44, No. 8, p 1245-1248(1997)]. Li₂O is a particularly interesting material in that it is an electrically insulating material with a very low work function. The work function of alkali metals themselves is very low, and it becomes even lower when oxidized: for example, work function decreases from 2.1 eV for Cs to about I eV for Cs₂O. Various alkali metal compounds have been reportedly used to form an insulating buffer layer for the purpose of lowering the electron injecting barrier: to name a few, Li₂O, LiBO_{2.} NaCl, KCl, K₂SiO₃, RbCl, and Cs O. Despite said improvement, the introduction of the insulating buffer layer poses a challenging new problem: deterioration of adhesion between an EL multilayer and aluminum, and consequent reduction of life time. Experimental results reveal evidences of poor adhesion either at the buffer layer/aluminum interface or at the EL multilayer/buffer layer interface, which is not too surprising when different characteristics of materials involved are taken into account. In short, the related art suffers from poor adhesion and short life time.

### SUMMARY OF THE INVENTION

Accordingly, the present invention is directed to an organic electroluminescent device that substantially obviates one or more of the problems due to limitations and disadvantages of the related art

An object of the present invention is to provide an organic EL device with a long life time as well as a high efficiency.

Additional features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

To achieve these and other advantages and in accordance with the purpose of the present invention, as embodied and broadly described, the organic electroluminescent device includes a layer I formed of at least one alkali metal, alkaline earth metal and/or compounds thereof between an EL multilayer and a cathode formed of a metal or an alloy, and a layer II formed between the layer I and the EL multilayer. In particular, the present invention provides organic electroluminescent (EL) device comprising, in sequence, a substrate, a first electrode, an EL multilayer, a layer II, a layer I, and a second electrode, wherein layer I is formed of at least one alkali metal, alkaline earth metal and/or compounds thereof, and layer II is formed of at least one material selected from those having chemical formula I as shown below: 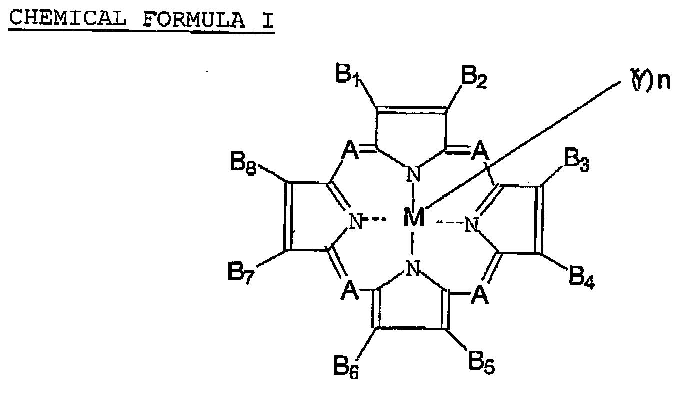 wherein:
A each independently denotes -N= or -C(R)=;
R is hydrogen, alkyl, alkoxyl, aralkyl, alkaryl, aryl, or heterocyclic group;
M is an element selected from IA, IIA, IIIA and IVA groups, and the third, fourth, fifth and sixth period groups in the periodic table;
Y is a material chosen from alkoxyl, phenoxyl, alkylamine, arylamine, alkylphosphine, arylphosphine, alkylsulphur, and arylsulphur groups, or an element selected from VIA and VIIA groups in the periodic table;
n is 0, 1 or 2; and,
B(B₁ ~ B₈) each independently represents hydrogen, alkyl, aryl, alkoxyl, aryloxyalkyl, hydroxyl, hydroxyalkyl, aralkyl, alkylamino, arylamino, alkylthiol, arylthiol, nitroalkyl, alkylcarbonyl, alkoxycarbonyl, phenyl, amine, cyanyl, naphthyl, alkaryl, halogen or a heterocyclic group, or two or more of which together complete an unsaturated or saturated five, six, or seven-membered ring, which preferably includes one or more substituents selected from alkyl, aryl, alkoxyl, aryloxyalkyl, hydroxyl, hydroxyalkyl, aralkyl, alkylamino, arylamino, nitroalkyl, alkylcarbonyl, alkoxycarbonyl, phenyl, amine, cyanyl, naphthyl, alkaryl, halogen and a heterocyclic group. Here the EL multilayer means a plurality of layers comprising a luminescent layer and typically all or a part of HIL, HTL, ETL, and EIL.

The porphyrinic compound which forms the layer II serves principally to improve the adhesion between the layer I and the EL multilayer while keeping a good electron transporting capability.

For B(B₁~B₃) preferred five, six or seven-membered rings are those formed of carbon, sulfur, oxygen and nitrogen ring atoms.

Highly preferred examples of useful porphyrinic compounds are phthalocyanines. Exemplary preferred materials are those of structural formulas II and III as shown below: 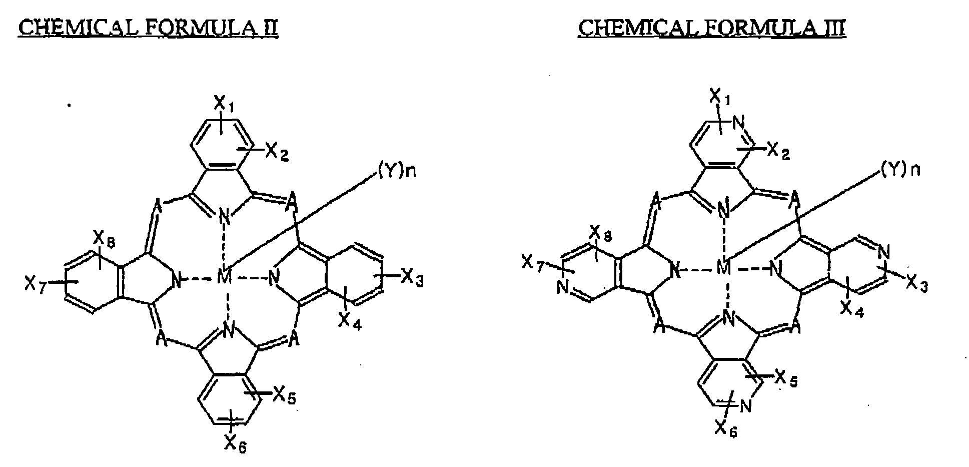 wherein
A each independently denotes -N= or -C(R)=;
R is hydrogen, alkyl, alkoxyl, aralkyl, alkaryl, aryl, or heterocyclic group;
M is an element selected from IA, IIA, IIIA and IVA groups, and the third, fourth, fifth and sixth period groups in the periodic table;
Y is a material chosen from alkoxyl, phenoxyl, alkylamine, arylamine, alkylphospine, Arylphospine, alkylsulphur, and arylsulphur groups, and an element selected from groups, and VIA and VIIA groups in the periodic table;
n is an integer of 0, 1, or 2; and,
X(X₁ ~ X₈) each independently represents hydrogen, alkyl, aryl, alkoxyl, aryloxyalkyl, hydroxyl, hydroxyalkyl, aralkyl, alkylamino, arylamino, alkylthiol, arylthiol, nitroalkyl, alkylcarbonyl, alkoxycarbonyl, phenyl, amine, cyanyl, naphthyl, alkaryl, halogen, or heterocyclic group, or together completes an unsaturated or saturated five, six, or seven-membered ring, which can include substituents such as alkyl, aryl, alkoxyl, aryloxyalkyl, hydroxyl, hydroxyalkyl, aralkyl, alkylamino, arylamino, nitroalkyl, alkylcarbonyl, alkoxycarbonyl, phenyl, amine, cyanyl, naphthyl, alkaryl, halogen, or heterocyclic group. Preferred five, six, or seven-membered rings are those formed of carbon, sulfur, oxygen and nitrogen ring atoms.

The most preferred examples of phthalocyanines are those of structural formulas IV and V as shown below: 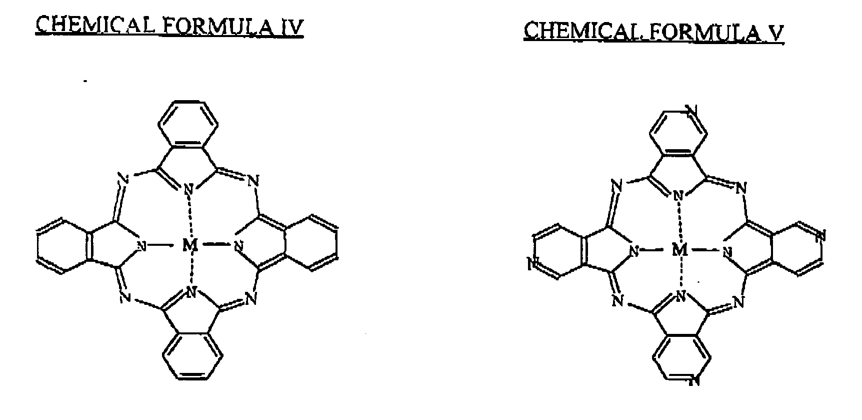 wherein
M is an element chosen from Co, AlCl, Cu, 2Li, Fe, Pb, Mg, SiCl₂, 2Na, Sn, Zn, Ni, Mn, VO, 2Ag, MnCl, and SnCl₃.

In the other aspect of this invention, there is provided a means to improve the life time as well as the electron injecting capability by inserting, instead of a dual layer of the layer I and me layer II, a mixture of the two layers between the EL multilayer and the cathode. The mixed layer may be formed by the co-deposition of (1) at least one alkali metal, alkaline earth metal, and/or compounds thereof and (2) the porphyrinic compounds herein described. The mixing ratio between the two groups of materials can be fixed or varied as a function of position in the thickness direction of layer.

It is to be understood that both the foregoing general description and the following detailed description all exemplary and explanatory, and are intended to provide further explanation of the invention as claimed.

### BRIEF DESCRIPTION OF THE DRAWINGS

The accompanying drawings, which are included to provide further understanding of the invention, and are incorporated in, and constitute a part of this specification, illustrate embodiments of the invention, and together with the description serve to explain the principles of the invention:
In the drawings:
   Fig. 1 illustrates a cross-sectional view of a background art organic EL device; and,
   Fig. 2 illustrates a cross-sectional view of an organic EL device in accordance with a preferred embodiment of the present invention.

### DETAILED DESCRIPTION OF THE PREFERRED EMBODIMENT

Reference will now be made in detail to the preferred embodiments of the present invention, an example of which is illustrated in the accompanying drawing. Fig. 2 schematically illustrates a sectional side view of an organic EL device in accordance with a preferred embodiment of the present invention.

Referring to Fig. 2, the organic EL device in accordance with a preferred embodiment of the present invention includes a laminated structure of a transparent substrate 21, an anode 22, an EL multilayer (typically of HIL, HTL, a luminescent layer, and ETL) 23, a cathode 24, and a protection film 25. Also inserted between the EL multilayer and the cathode are a layer I (27) and a layer II (26) which primarily serve for improving electron injection and adhesion, respectively. In the invention, at least one porphyrinic compound forms the layer II which serves principally to improve the adhesion between the layer I and the EL multilayer while keeping a good electron transporting capability. The porphyrinic compounds are those of structural formula I as shown below: 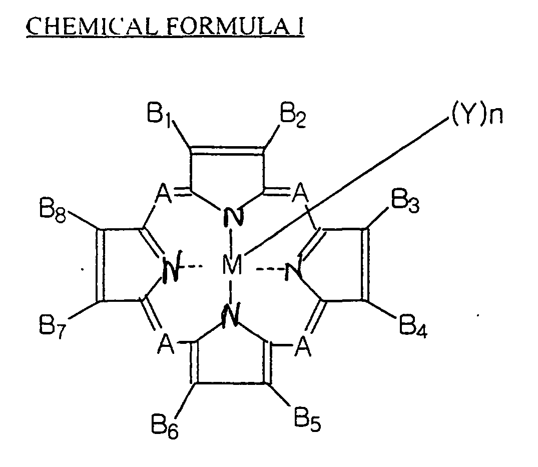 wherein
A each independently denotes -N= or -C(R)=;
R is hydrogen, alkyl, alkoxyl, aralkyl, alkaryl, aryl, or heterocyclic group;
M is an element selected from IA, IIA, IIIA and IVA groups, and the third, fourth, fifth and sixth period groups in the periodic table;
Y is a material chosen from alkoxyl, phenoxyl, alkylamine, arylamine, alkylphospine, arylphospine, alkylsulphur, and arylsulphur groups, and an element selected from VIA and VIIA groups in the periodic table;
n is an integer of 0, 1, or 2; and,
B(B₁ ~ B₈) each independently represents hydrogen, alkyl, aryl, alkoxyl, aryloxyalkyl, hydroxyl, hydroxyalkyl, aralkyl, alkylamino, arylamino, alkylthiol, arylthiol, nitroalkyl, alkylcarbonyl, alkoxycarbonyl, phenyl, amine, cyanyl, naphthyl, alkaryl, halogen, or heterocyclic group, or together completes an unsaturated or saturated five, six, or seven-membered ring, which can include substituents such as alkyl, aryl, alkoxyl, aryloxyalkyl, hydroxyl, hydroxyalkyl, aralkyl, alkylamino, arylamino, nitroalkyl, alkylcarbonyl, alkoxycarbonyl, phenyl, amine, cyanyl, naphthyl, alkaryl, halogen, or heterocyclic group. Preferred five, six, or seven-membered rings are those formed of carbon, sulfur, oxygen and nitrogen ring atoms.

Highly preferred examples of useful porphyrinic compounds are phthalocyanines. Exemplary preferred phthalocyanines are those of structural formulas II and III as shown below: 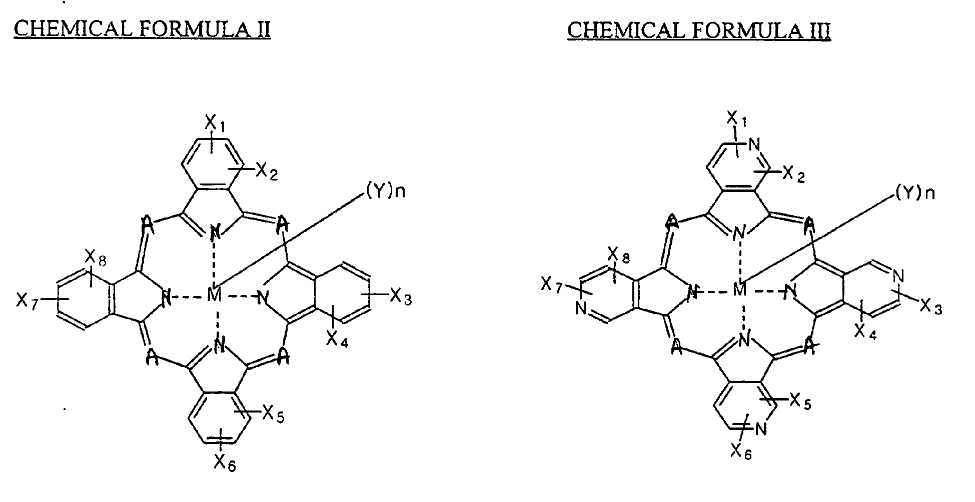 wherein
A each independently denotes -N= or -C(R)=;
R is hydrogen, alkyl, alkoxyl, aralkyl, alkaryl, aryl, or heterocyclic group;
M is an element selected from IA, IIA, IIIA and IVA groups, and the third, fourth, fifth and sixth period groups in the periodic table;
Y is a material chosen from alkoxyl, phenoxyl, alkylamine, arylamine, alkylphospine, Arylphospine, alkylsulphur, and arylsulphur groups, and an element selected from groups, and VIA and VIIA groups in the periodic table;
n is an integer of 0, 1, or 2; and,
X(X₁ ~ X₈) each independently represents hydrogen, alkyl, aryl, alkoxyl, aryloxyalkyl, hydroxyl, hydroxyalkyl, aralkyl, alkylamino, arylamino, alkylthiol, arylthiol, nitroalkyl, alkylcarbonyl, alkoxycarbonyl, phenyl, amine, cyanyl, naphthyl, alkaryl, halogen, or heterocyclic group, or together completes an unsaturated or saturated five, six, or seven-membered ring, which can include substituents such as alkyl, aryl, alkoxyl, aryloxyalkyl, hydroxyl, hydroxyalkyl, aralkyl, alkylamino, arylamino, nitroalkyl, alkylcarbonyl, alkoxycarbonyl, phenyl, amine, cyanyl, naphthyl, alkaryl, halogen, or heterocyclic group. Preferred five, six, or seven-membered rings are those formed of carbon, sulfur, oxygen and nitrogen ring atoms.

Preferentially, said M of chemical formulas I ~ III may be chosen from 2Li, 2Na, Mg, T₁, V, Cr. Mn, Fe, Co, Ni, Pt, Cu, 2Ag, Zn, Al, Ga, In, Si, Sn, Pb, and 2H, and said Y of chemical formulas I - III may be selected from oxygen, fluorine, chlorine, bromine, alkoxyl group (alkyl moieties contain from about 1 to 10 carbon atoms), and phenoxyl group.

The most preferred examples of phthalocyanines are those of structural formulas IV and V as shown below: 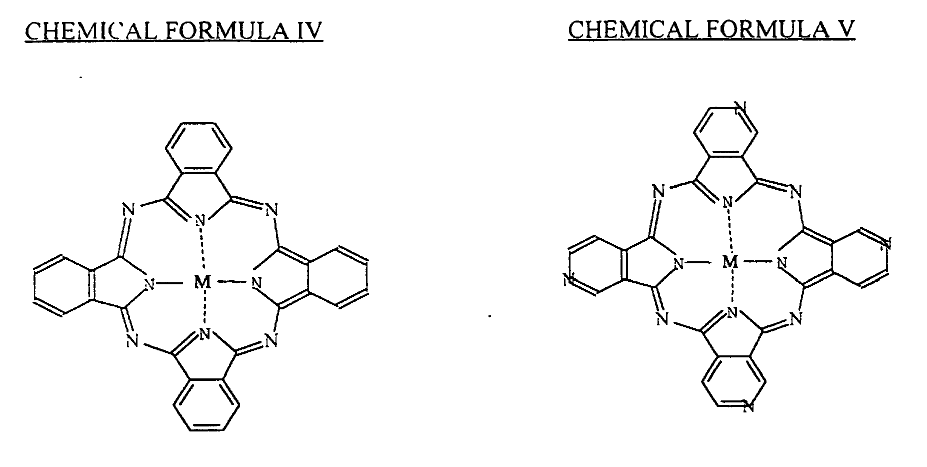 wherein
M is an element chosen from Co, AlCl, Cu, 2Li, Fe, Pb, Mg, SiCl₂, 2Na, Sn, Zn, Ni, Mn, VO, 2Ag, MnCl, and SnCl₂.

The layer 1 (27) is designed to improve the electron injection capability and is formed of at least one alkali metal, alkaline earth metal, or its compound. Exemplary preferred materials are Li, Cs, Li₂O, and LiF. The cathode 24 is formed of a metal or its alloy, and aluminum is most preferred.

The organic EL device of the present invention having the layer I (27) and the layer II (26) thus stacked between the EL multilayer 23 and the cathode 24 shows a substantially prolonged life time as well as a high luminance. If the layer I (27) and the layer II (26) are stacked in the opposite sequence, which is not covered by the invention, this results in the decrease of luminance and life time. The layer I (27) and the layer II (26) may have a thickness of approx. 0.2 nm ~ 3 nm and 0.5 nm ~ 50 nm, respectively.

Exemplary devices have been fabricated in accordance with the present invention, and their performance has been compared with those of the background art: three devices of A, B and D are of the background art, and the other device of C is of the present invention. The basic device structure for green emission constitutes (1) an anode of indium tin oxide (ITO) 150 nm thick, (2) a butter layer of copper phthalocyanine (CuPc) typically 10nm - 20nm thick, (3) a hole transporting layer ofN,N'-diphenyl-N,N'-bis(3-methylphenyl)-(1,1'-biphenyl)-4,4'-diamine (TPD) typically 30nm ~ 50nm thick, and (4) an emitting layer of tris(8-hydroxyquinolate)aluminum (Alq₃ 40nm ~ 60nm thick. The device A has a cathode of aluminum formed directly on the EL multilayer (device structure: ITO/CuPc/TPD/Alq₃/Al) while the device B has a layer of Li₂O 1 nm thick between the EL multilayer and the cathode (ITO/CuPc/TPD/AlQ₃/Li₂O (1nm)/Al). The device C has a structure of ITO/CuPc/TPD/Alq₃/CuPc(2nm)/Li₂O(1nm)/Al while the device D has a structure of ITO/CuPc/TPD/Alq₃/Li₂O(1nm)/CuPc(2nm)/Al. In short, the layer-forming sequence of Li₂O(1nm) and CuPc(2nm) is reversed for the devices C and D. Finally, all devices have been encapsulated in an inert atmosphere.

TABLE I below lists the voltage measured between an anode and a cathode, luminance, and life time with the samples subjected to a constant current density of 3 mA/cm².

**TABLE I**

| | voltage (V) | luminance (cd/m²) | life time |
|---|---|---|---|
| Device A | 6 | 50 | short (less than 1 hour) |
| Device B | 6 | 100 | short (less than 1 hour) |
| Device C | 6 | 150 | long (longer than 2000 hours) |
| Device D | 8 | 130 | intermediate (roughly 100 hours) |

The life time quoted in the above table represents the time by which luminance drops to half the initial value for each device. It is apparent in TABLE 1 that the device C of the present invention is superior in the long-term stability to the devices A, B and D of the background art, which can be explained as follows. Li₂O shows poor adhesion with both Alq₃ and aluminum. In addition, a 1 nm-thick layer of Li₂O does not form a complete and uniform layer, but rather a kind of island structure. A part of the CuPc layer is apparently in direct contact with aluminum through the open space in the Li₂O layer, which significantly contributes to enhancing the adhesion of the organic/metal interface and consequently the life time of devices. The copper ion in CuPc is probably responsible for the relatively strong bonding between CuPc and aluminum. Compared to the device C. the device D exhibits a higher driving voltage because of the raised electron-injection barrier due to the presence of CuPc between Li₂O and aluminum, and consequently a shorter life time due to the increased electrical and thermal stress

In the other aspect of this invention, there is provided a means to improve the life time as well as the electron injecting capability by inserting, instead of a dual layer of the layer I (27) and the layer II (26) in Fig. 2, a mixture of the two layers between the EL multilayer and the cathode. The mixed layer may be formed by the co-deposition of (1) at least one alkali metal, alkaline earth metal, or its compound, and (2) at least one porphyrinic compound. The use of the mixed layer improves adhesion, but deteriorates electron infection slightly. The mixing ratio between the two groups of materials can be fixed or varied as a function of position, and the best performance has been obtained with (1) the relative concentration of the material(s) selected from a group of alkali metals, alkaline earth metals and their compounds being zero at the interface with the EL multilayer, and unity at the interface with the cathode, and varying gradually in between, and (2) the relative concentration of porphyrinic compound(s) being unity at the interface with the EL multilayer, and zero at the interface with the cathode, and varying gradually in between. The thickness of the mixed layer is in the range of 0.5 nm - 10 nm.

The organic EL devices of the present invention have the following advantages.

Inserting either a dual layer of a layer and a layer II or a mixture of the two layers between the EL multilayer and the cathode helps to improve significantly the long-term stability as well as the luminance, with the layer II being formed of at least one material selected from those having chemical formula I, and with the layer I being made of at least one alkali metal, alkaline earth metal, or its compound.

## Claims

1. An organic electroluminescent (EL) device comprising, in sequence, a substrate, a first electrode, an EL multilayer, a layer II, a layer I, and a second electrode, wherein layer I is formed of at least one alkali metal, alkaline earth metal and/or compounds thereof, and layer II is formed of at least one material selected from those having chemical formula I as shown below: 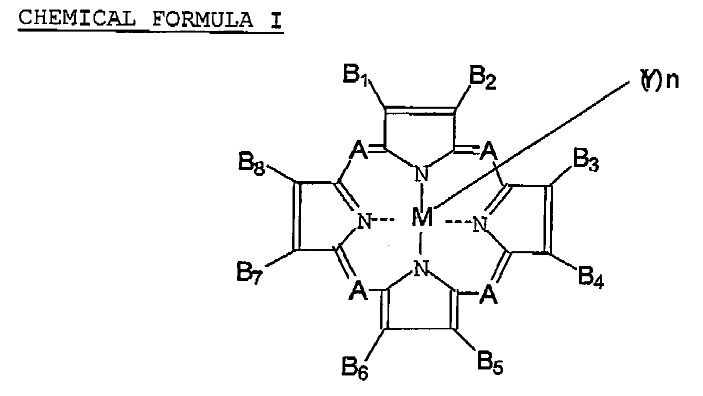 wherein:
A each independently denotes -N= or -C(R)=;
R is hydrogen, alkyl, alkoxyl, aralkyl, alkaryl, aryl or heterocyclic group;
M is an element selected from IA, IIA, IIIA and IVA groups, and the third, fourth, fifth and sixth period groups in the periodic table;
Y is a material chosen from alkoxyl, phenoxyl, alkylamine, arylamine, alkylphosphine, arylphosphine, alkylsulphur and arylsulphur groups, or an element selected from VIA and VIIA groups in the periodic table;
n is 0, 1 or 2; and
B(B₁ ~ B₈) each independently represents hydrogen, alkyl, aryl, alkoxyl, aryloxyalkyl, hydroxyl, hydroxyalkyl, aralkyl, alkylamino, arylamino, alkylthiol, arylthiol, nitroalkyl, alkylcarbonyl, alkoxycarbonyl, phenyl, amine, cyanyl, naphthyl, alkaryl, halogen or a heterocyclic group, or two or more of which together complete an unsaturated or saturated five, six or seven-membered ring, which preferably includes one or more substituents selected from alkyl, aryl, alkoxyl, aryloxyalkyl, hydroxyl, hydroxyalkyl, aralkyl, alkylamino, arylamino, nitroalkyl, alkylcarbonyl, alkoxycarbonyl, phenyl, amine, cyanyl, naphthyl, alkaryl, halogen and a heterocyclic group.

2. A device as claimed in claim 1, wherein layer I has a thickness of 0.2 nm to 3 nm, and the layer II has a thickness of 0.5 nm to 50 nm.

3. A device as claimed in claim 1 or claim 2, wherein layer I is formed of Li₂O.

4. A device as claimed in any one of the preceding claims, wherein layer II is formed of at least one material selected from those having chemical formulae II and III as shown below: 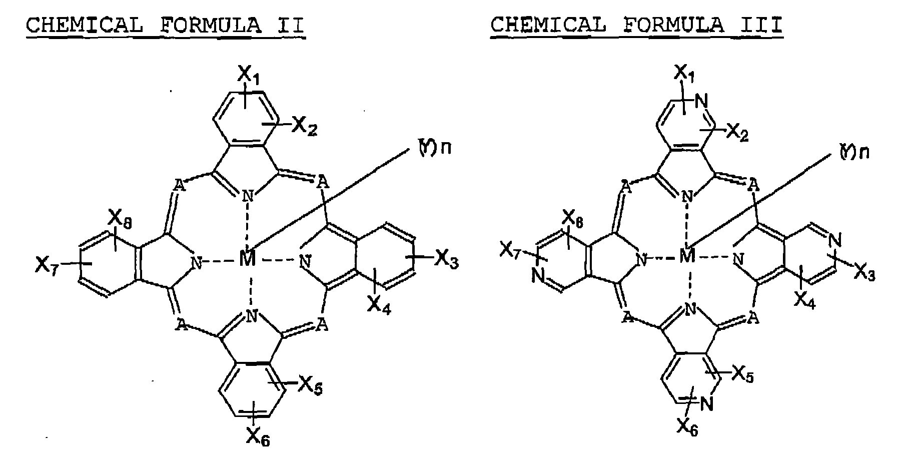 wherein:
A each independently denotes -N= or -C(R)=;
R is hydrogen, alkyl, alkoxyl, aralkyl, alkaryl aryl or a heterocyclic group;
M is an element selected from IA, IIA, IIIA and IVA groups, and the third, fourth, fifth and sixth period groups in the periodic table;
Y is a material selected from alkoxyl, phenoxyl, alkylamine, arylamine, alkylphosphine, arylphosphine, alkylsulphur and arylsulphur groups, or an element selected from groups VIA and VIIA groups in the periodic table;
n is 0, 1 or 2; and,
X(X₁ ~ X₈) each independently represents hydrogen, alkyl, aryl, alkoxyl, aryloxyalkyl, hydroxyl, hydroxyalkyl, aralkyl, alkylamino, arylamino, alkylthiol, arylthiol, nitroalkyl, alkylcarbonyl, alkoxycarbonyl, phenyl, amine, cyanyl, naphthyl, alkaryl, halogen or a heterocyclic group, or two or more of which together complete an unsaturated or saturated five, six, or seven-membered ring, which preferably includes one or more substituents selected from alkyl, aryl, alkoxyl, aryloxyalkyl, hydroxyl, hydroxyalkyl, aralkyl, alkylamino, arylamino, nitroalkyl, alkylcarbonyl, alkoxycarbonyl, phenyl, amine, cyanyl, naphthyl, alkaryl, halogen and a heterocyclic group.

5. A device as claimed in any one of the preceding claims, wherein layer II is formed of at least one material selected from those having chemical formulae IV and V as shown below: 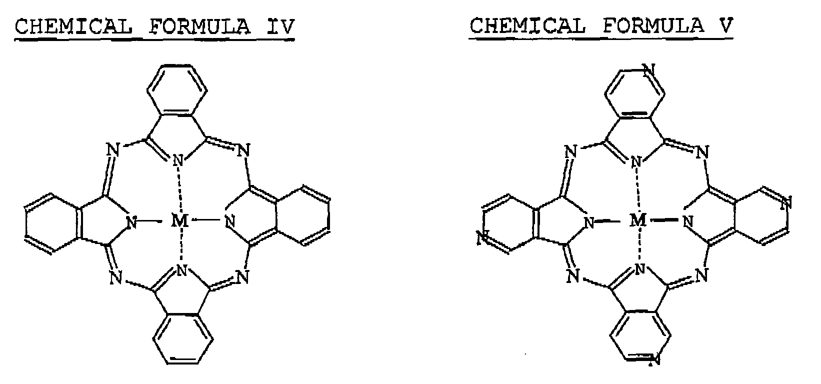 wherein M is selected from Co, AlCl, Cu, 2Li, Fe, Pb, Mg, SiCl₂, 2Na, Sn, Zn, Ni, Mn, VO, 2Ag, MnCl, and SnCl₂-

6. An organic electroluminescent (EL) device comprising, in sequence, a first electrode, an EL multilayer, a mixed layer and a second electrode, wherein the mixed layer comprises a first material and a second material, the first material being selected from a first group of alkali metals, alkaline earth metals and/or compounds thereof, and the second material being selected from a second group of the materials having formula I: 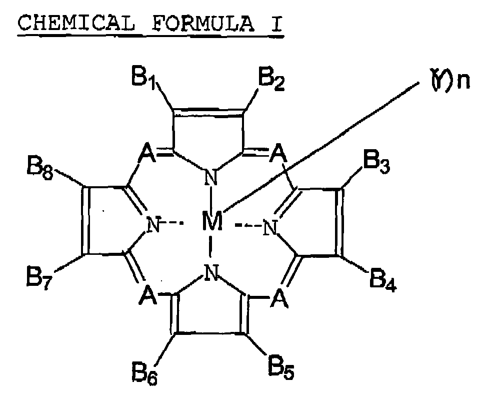 wherein:
A each independently denotes -N= or -C(R)=;
R is hydrogen, alkyl, alkoxyl, aralkyl, alkaryl, aryl or heterocyclic group;
M is an element selected from IA, IIA, IIIA and IVA groups, and the third, fourth, fifth and sixth period groups in the periodic table;
Y is a material chosen from alkoxyl, phenoxyl, alkylamine, arylamine, alkylphosphine, arylphosphine, alkylsulphur and arylsulphur groups, or an element selected from VIA and VIIA groups in the periodic table;
n is 0, 1, or 2; and,
B(B₁ ~ B₈) each independently represents hydrogen, alkyl, aryl, alkoxyl, aryloxyalkyl, hydroxyl, hydroxyalkyl, aralkyl, alkylamino, arylamino, alkylthiol, arylthiol, nitroalkyl, alkylcarbonyl, alkoxycarbonyl, phenyl, amine, cyanyl, naphthyl, alkaryl, halogen or a heterocyclic group, or two or more of which together complete an unsaturated or saturated five, six or seven-membered ring, which preferably includes one or more substituents selected from alkyl, aryl, alkoxyl, aryloxyalkyl, hydroxyl, hydroxyalkyl, aralkyl, alkylamino, arylamino, nitroalkyl, alkylcarbonyl, alkoxycarbonyl, phenyl, amine, cyanyl, naphthyl, alkaryl, halogen and a heterocyclic group.

7. A device as claimed in any one of claims 2, 3 and 6, wherein two or more of B (B₁ ~ B₈) together complete an unsaturated or saturated five, six or seven-membered ring formed of one or more of carbon, sulfur, oxygen and/or nitrogen atoms.

8. A device as claimed in any one of claims 2, 3, 6 and 7, wherein said M of chemical formula I is selected from 2Li, 2Na, Mg, Ca, Ti, V, Cr, Mn, Fe, Co, Ni, Pt, Cu, 2Ag, Zn, Pd, Al Ga, In, Si, Sn, Pb, and 2H.

9. A device as claimed in any one of claims 2, 3, or 6 to 8, wherein said Y of chemical formula I is selected from oxygen, fluorine, chlorine, bromine, alkoxyl group where the alkyl moieties contain from about 1 to 10 carbon atoms, and a phenoxyl group.

10. A device as claimed in claim 6, wherein the mixing ratio between said first and second materials is either fixed or varied as a function of position in the thickness direction of the layer.

11. A device as claimed in any one of claims 6 and 10, wherein the mixed layer has a thickness of from 0.5 nm to 10 nm.

12. A device as claimed in any one of the preceding claims, wherein the second electrode is formed of aluminum.

13. A device as claimed in any one of claims 6 and 10 to 12, wherein the first material of the first group is Li₂O.

14. A device as claimed in any one of claims 6 and 10 to 13, wherein the second material is selected from those having chemical formulae II and III as shown below: 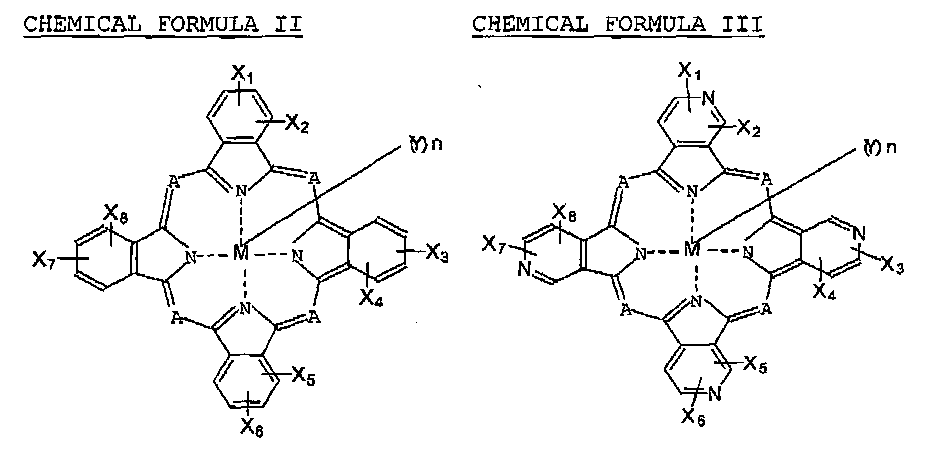 wherein:
A each independently denotes -N= or -C(R)=;
R is hydrogen, alkyl, alkoxyl, aralkyl, alkaryl, aryl or a heterocyclic group;
M is an element selected from IA, IIA, IIIA and IVA groups, and the third, fourth, fifth and sixth period groups in the periodic table;
Y is a material selected from alkoxyl, phenoxyl, alkylamine, arylamine, alkylphosphine, arylphosphine, alkylsulphur and arylsulphur groups, or an element selected from groups VIA and VIIA groups in the periodic table;
n is 0, 1, or 2; and,
X(X₁ ~ X₈) each independently represents hydrogen, alkyl, aryl, alkoxyl, aryloxyalkyl, hydroxyl, hydroxyalkyl, aralkyl, alkylamino, arylamino, alkylthiol, arylthiol, nitroalkyl, alkylcarbonyl, alkoxycarbonyl, phenyl, amine, cyanyl, naphthyl, alkaryl, halogen or a heterocyclic group, or two or more of which together complete an unsaturated or saturated five, six, or seven-membered ring, which preferably includes one or more substituents selected from alkyl, aryl, alkoxyl, aryloxyalkyl, hydroxyl, hydroxyalkyl, aralkyl, alkylamino, arylamino, nitroalkyl, alkylcarbonyl, alkoxycarbonyl, phenyl, amine, cyanyl, naphthyl, alkaryl, halogen and a heterocyclic group.

15. A device as claimed in claim 4 or claim 14, wherein said M of chemical formulas II and III is selected from 2Li, 2Na, Mg, Ca, Ti, V, Cr, Mn, Fe, Co, Ni, Pt, Cu, 2Ag, Zn, Pd, Al, Ga, In, Si, Sn, Pb and 2H.

16. A device as claimed in claims 4, 14 and 15, wherein said Y of chemical formulas II and III is selected from oxygen, fluorine, chlorine, bromine, alkoxyl group where the alkyl moieties contain from about 1 to 10 carbon atoms, and phenoxyl group.

17. A device as claimed in any one of claims 4 and 14 to 16, wherein two or more of X(X₁ ~ X₈) together complete an unsaturated or saturated five, six or seven-membered ring formed of one or more of carbon, sulfur, oxygen and/or nitrogen atoms.

18. A device as claimed in any one of claims 14 to 17, wherein the second material is selected from those having chemical formulae IV and V as shown below: 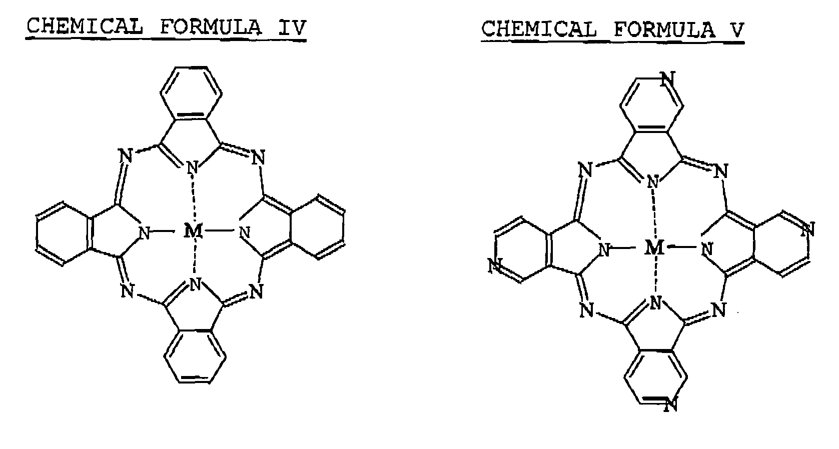 wherein M is selected from Co, AlCl, Cu, 2Li, Fe, Pb, Mg, SiCl₂, 2Na, Sn, Zn, Ni, Mn, VO, 2Ag, MnCl and SnCl₂.

## Patentansprüche

1. Organische elektrolumineszente (EL) Vorrichtung umfassend der Reihe nach ein Substrat, eine erste Elektrode, eine EL Multilayer, eine Schicht II, eine Schicht I und eine zweite Elektrode, wobei Schicht I aus mindestens einem Alkalimetall, Erdalkalimetall und/oder Verbindungen davon gebildet wird und Schicht II aus mindestens einem Material gebildet wird, das ausgewählt ist aus denen mit der chemischen Formel I wie unten gezeigt: 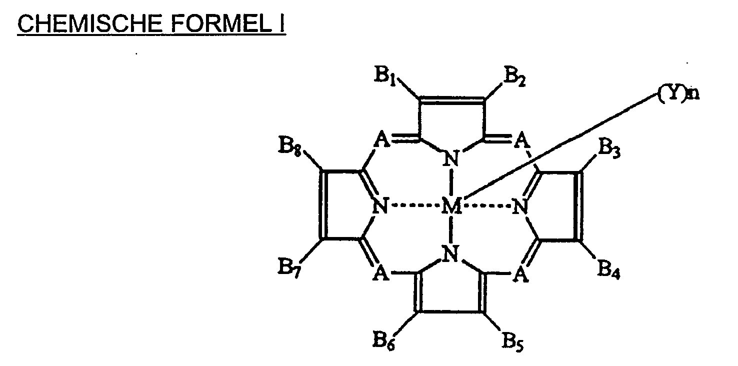 wobei:
A jedes unabhängig -N= oder -C(R)= bedeutet;
R Wasserstoff, Alkyl, Alkoxyl, Aralkyl, Alkaryl, Aryl oder eine heterocyclische Gruppe ist;
M ein Element ausgewählt aus IA-, IIA-, IIIA- und IVA-Gruppen und den dritten, vierten, fünften und sechsten Periodengruppen des Periodensystems ist;
Y ein Material ausgewählt aus Alkoxyl-, Phenoxyl-, Alkylamin-, Arylamin-, Alkylphosphin-, Arylphosphin-, Alkylschwefel- und Arylschwefel-Gruppen oder ein Element ausgewählt aus VIA- und VIIA-Gruppen des Periodensystems ist;
n 0, 1 oder 2 ist; und
B(B₁ ~ B₈) jedes unabhängig Wasserstoff, Alkyl, Aryl, Alkoxyl, Aryloxyalkyl, Hydroxyl, Hydroxyalkyl, Aralkyl, Alkylamino, Arylamino, Alkylthiol, Arylthiol, Nitroalkyl, Alkylcarbonyl, Alkoxycarbonyl, Phenyl, Amin, Cyanyl, Naphthyl, Alkaryl, Halogen oder eine heterocyclische Gruppe darstellt oder zwei oder mehr von diesen zusammen einen ungesättigten oder gesättigten fünf-, sechs- oder sieben-Ring vervollständigen, der vorzugsweise einen oder mehrere Substituenten ausgewählt aus Alkyl, Aryl, Alkoxyl, Aryloxyalkyl, Hydroxyl, Hydroxyalkyl, Aralkyl, Alkylamino, Arylamino, Nitroalkyl, Alkylcarbonyl, Alkoxycarbonyl, Phenyl, Amin, Cyanyl, Naphthyl, Alkaryl, Halogen und einer heterocyclischen Gruppe einschließt.

2. Vorrichtung nach Anspruch 1, wobei Schicht 1 eine Dicke von 0,2 nm bis 3 nm hat und Schicht II eine Dicke von 0,5 nm bis 50 nm hat.

3. Vorrichtung nach Anspruch 1 oder Anspruch 2, wobei Schicht I aus Li₂O gebildet wird.

4. Vorrichtung nach einem der vorherigen Ansprüche, wobei Schicht II aus mindestens einem Material gebildet wird, das ausgewählt ist aus denen mit den chemischen Formeln II und III wie unten gezeigt: 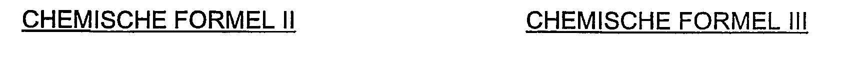 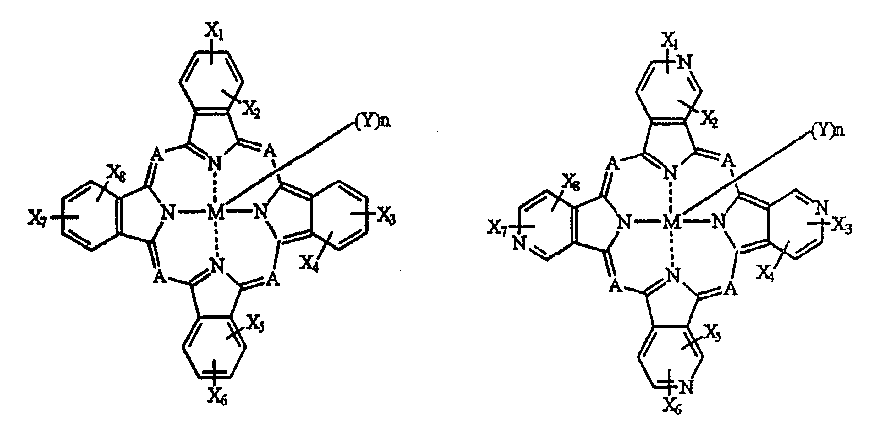 wobei:
A jedes unabhängig -N= oder -C(R)= bedeutet;
R Wasserstoff, Alkyl, Alkoxyl, Aralkyl, Alkaryl, Aryl oder eine heterocyclische Gruppe ist;
M ein Element ausgewählt aus IA-, IIA-, IIIA- und IVA-Gruppen und den dritten, vierten, fünften und sechsten Periodengruppen des Periodensystems ist;
Y ein Material ausgewählt aus Alkoxyl-, Phenoxyl-, Alkylamin-, Arylamin-, Alkylphosphin-, Arylphosphin-, Alkylschwefel- und Arylschwefel-Gruppen, oder ein Element ausgewählt aus den Gruppen VIA- und VIIA-Gruppen des Periodensystems ist;
n 0, 1 oder 2 ist; und,
X(X₁ ~ X₈) jedes unabhängig Wasserstoff, Alkyl, Aryl, Alkoxyl, Aryloxyalkyl, Hydroxyl, Hydroxyalkyl, Aralkyl, Alkylamino, Arylamino, Alkylthiol, Arylthiol, Nitroalkyl, Alkylcarbonyl, Alkoxycarbonyl, Phenyl, Amin, Cyanyl, Naphthyl, Alkaryl, Halogen oder eine heterocyclische Gruppe darstellt, oder zwei oder mehr von diesen zusammen einen ungesättigten oder gesättigten fünf-, sechs- oder sieben-Ring vervollständigen, der vorzugsweise einen oder mehrere Substituenten, ausgewählt aus Alkyl, Aryl, Alkoxyl, Aryloxyalkyl, Hydroxyl, Hydroxyalkyl, Aralkyl, Alkylamino, Arylamino, Nitroalkyl, Alkylcarbonyl, Alkoxycarbonyl, Phenyl, Amin, Cyanyl, Naphthyl, Alkaryl, Halogen und einer heterocyclischen Gruppe einschließt.

5. Vorrichtung nach einem der vorherigen Ansprüche, wobei Schicht II aus mindestens einem Material gebildet wird, das ausgewählt ist aus denen mit den chemischen Formeln IV und V wie unten gezeigt: 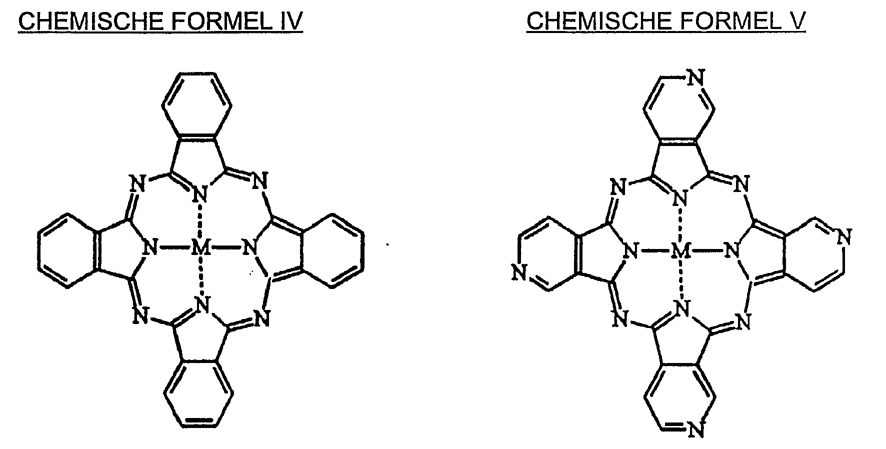 wobei M ausgewählt ist aus Co, AlCl, Cu, 2Li, Fe, Pb, Mg, SiCl₂, 2Na, Sn, Zn, Ni, Mn, VO, 2Ag, MnCl und SnCl₂.

6. Organische elektrolumineszente (EL) Vorrichtung umfassend der Reihe nach eine erste Elektrode, eine EL Multilayer, eine gemischte Schicht und eine zweite Elektrode, wobei die gemischte Schicht ein erstes Material und ein zweites Material umfasst, wobei das erste Material ausgewählt ist aus einer ersten Gruppe von Alkalimetallen, Erdalkalimetallen und/oder Verbindungen davon und wobei das zweite Material ausgewählt ist aus einer zweiten Gruppe von Materialien mit der Formel I: 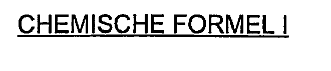 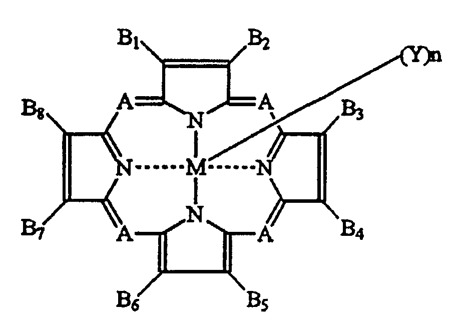 wobei:
A jedes unabhängig -N= or -C(R)= bedeutet;
R Wasserstoff, Alkyl, Alkoxyl, Aralkyl, Alkaryl, Aryl oder eine heterocyclische Gruppe ist;
M ein Element ausgewählt aus IA-, IIA-, IIIA- und IVA-Gruppen und den dritten, vierten, fünften und sechsten Periodengruppen des Periodensystems ist;
Y ein Material ausgewählt aus Alkoxyl-, Phenoxyl-, Alkylamin-, Arylamin-, Alkylphosphin-, Arylphosphin-, Alkylschwefel- und Arylschwefel-Gruppen oder ein Element ausgewählt aus VIA- und VIIA-Gruppen des Periodensystems ist;
n 0, 1 oder 2 ist; und,
B(B₁ ~ B₈) jedes unabhängig Wasserstoff, Alkyl, Aryl, Alkoxyl, Aryloxyalkyl, Hydroxyl, Hydroxyalkyl, Aralkyl, Alkylamino, Arylamino, Alkylthiol, Arylthiol, Nitroalkyl, Alkylcarbonyl, Alkoxycarbonyl, Phenyl, Amin, Cyanyl, Naphthyl, Alkaryl, Halogen oder eine heterocyclische Gruppe darstellt, oder zwei oder mehr von diesen zusammen einen ungesättigten oder gesättigten fünf-, sechs- oder sieben-Ring vervollständigen, der vorzugsweise einen oder mehrere Substituenten, ausgewählt aus Alkyl, Aryl, Alkoxyl, Aryloxyalkyl, Hydroxyl, Hydroxyalkyl, Aralkyl, Alkylamino, Arylamino, Nitroalkyl, Alkylcarbonyl, Alkoxycarbonyl, Phenyl, Amin, Cyanyl, Naphthyl, Alkaryl, Halogen und einer heterocyclischen Gruppe einschließt.

7. Vorrichtung nach einem der Ansprüche 2, 3 und 6, wobei zwei oder mehr von B(B₁ ~ B₈) zusammen einen ungesättigten oder gesättigten fünf-, sechs- oder sieben-Ring vervollständigen, der aus einem oder mehreren von Kohlenstoff-, Schwefel-, Sauerstoff- und/oder Stickstoffatomen gebildet wird.

8. Vorrichtung nach einem der Ansprüche 2, 3, 6 und 7, wobei das M der chemischen Formel I ausgewählt ist aus 2Li, 2Na, Mg, Ca, Ti, V, Cr, Mn, Fe, Co, Ni, Pt, Cu, 2Ag, Zn, Pd, Al, Ga, In, Si, Sn, Pb und 2H.

9. Vorrichtung nach einem der Ansprüche 2, 3 oder 6 bis 8, wobei das Y der chemischen Formel I ausgewählt ist aus Sauerstoff, Fluor, Chlor, Brom, Alkoxyl-Gruppe, wobei die Alkyl-Reste von etwa 1 bis 10 Kohlenstoffatome enthalten, und einer Phenoxyl-Gruppe.

10. Vorrichtung nach Anspruch 6, wobei das Mischungsverhältnis zwischen den ersten und zweiten Materialien entweder festgelegt ist oder abhängig von der Position in der Dickenrichtung der Schicht variiert.

11. Vorrichtung nach einem der Ansprüche 6 und 10, wobei die gemischte Schicht eine Dicke von 0,5 nm bis 10 nm hat.

12. Vorrichtung nach einem der vorherigen Ansprüche, wobei die zweite Elektrode aus Aluminium gebildet wird.

13. Vorrichtung nach einem der Ansprüche 6 und 10 bis 12, wobei das erste Material der ersten Gruppe Li₂O ist.

14. Vorrichtung nach einem der Ansprüche 6 und 10 bis 13, wobei das zweite Material ausgewählt ist aus denen mit den chemischen Formeln II und III wie unten gezeigt: 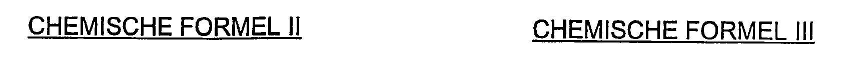 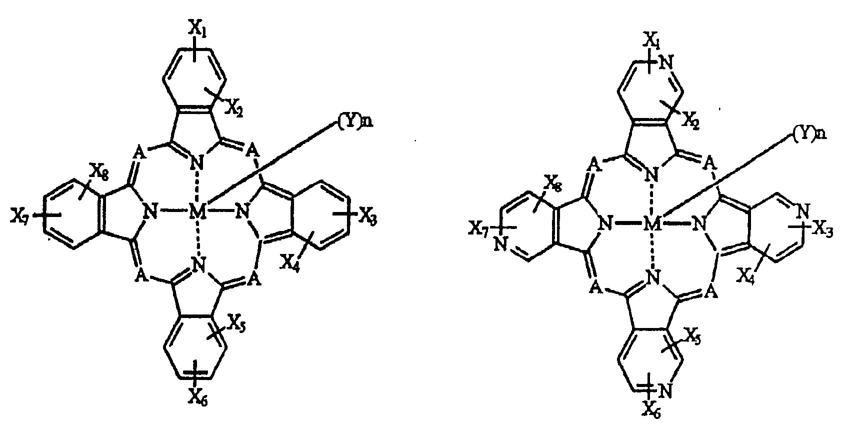 wobei:
A jedes unabhängig -N= or -C(R)= bedeutet;
R Wasserstoff, Alkyl, Alkoxyl, Aralkyl, Alkaryl, Aryl oder eine heterocyclische Gruppe ist;
M ein Element ausgewählt aus IA-, IIA-, IIIA- und IVA-Gruppen und den dritten, vierten, fünften und sechsten Periodengruppen des Periodensystems ist;
Y ein Material ausgewählt aus Alkoxyl-, Phenoxyl-, Alkylamin-, Arylamin-, Alkylphosphin-, Arylphosphin-, Alkylschwefel- und Arylschwefel-Gruppen oder ein Element ausgewählt aus Gruppen VIA- und VIIA-Gruppen des Periodensystems ist;
n 0, 1 oder 2 ist; und,
X(X₁ ~ X₈) jedes unabhängig Wasserstoff, Alkyl, Aryl, Alkoxyl, Aryloxyalkyl, Hydroxyl, Hydroxyalkyl, Aralkyl, Alkylamino, Arylamino, Alkylthiol, Arylthiol, Nitroalkyl, Alkylcarbonyl, Alkoxycarbonyl, Phenyl, Amin, Cyanyl, Naphthyl, Alkaryl, Halogen oder eine heterocyclische Gruppe darstellt, oder zwei oder mehrere von diesen zusammen einen ungesättigten oder gesättigten fünf-, sechs-, oder sieben-Ring vervollständigen, der vorzugsweise einen oder mehrere Substituenten, ausgewählt aus Alkyl, Aryl, Alkoxyl, Aryloxyalkyl, Hydroxyl, Hydroxyalkyl, Aralkyl, Alkylamino, Arylamino, Nitroalkyl, Alkylcarbonyl, Alkoxycarbonyl, Phenyl, Amin, Cyanyl, Naphthyl, Alkaryl, Halogen und einer heterocyclischen Gruppe einschließt.

15. Vorrichtung nach Anspruch 4 oder Anspruch 14, wobei das M der chemischen Formeln II und III ausgewählt ist aus 2Li, 2Na, Mg, Ca, Ti, V, Cr, Mn, Fe, Co, Ni, Pt, Cu, 2Ag, Zn, Pd, Al, Ga, In, Si, Sn, Pb und 2H.

16. Vorrichtung nach einem der Ansprüche 4, 14 und 15, wobei das Y der chemischen Formeln II und III ausgewählt ist aus Sauerstoff, Fluor, Chlor, Brom, Alkoxyl-Gruppe, wobei die Alkyl-Reste von etwa 1 bis 10 Kohlenstoffatome enthalten, und Phenoxyl-Gruppe.

17. Vorrichtung nach einem der Ansprüche 4 und 14 bis 16, wobei zwei oder mehr von X(X₁ ~ X₈) zusammen eine ungesättigten oder gesättigten fünf-, sechs-, oder sieben-Ring vervollständigen, der aus einem oder mehreren von Kohlenstoff-, Schwefel-, Sauerstoff- und/oder Stickstoffatomen gebildet wird.

18. Vorrichtung nach einem der Ansprüche 14 bis 17, wobei das zweite Material ausgewählt ist aus denen mit den chemischen Formeln IV und V wie unten gezeigt: 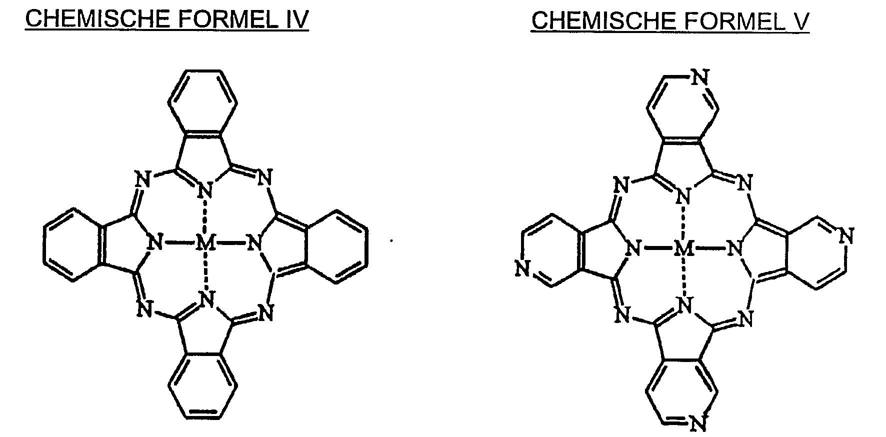 wobei M ausgewählt ist aus Co, AlCl, Cu, 2Li, Fe, Pb, Mg, SiCl₂, 2Na, Sn, Zn, Ni, Mn, VO, 2Ag, MnCl und SnCl₂.

## Revendications

1. Dispositif organique électroluminescent (EL) comprenant, de manière séquentielle, un substrat, une première électrode, une multicouche EL, une couche II, une couche I, et une deuxième électrode, dans lequel la couche I est formée d'au moins un métal alcalin, un métal alcalino-terreux et/ou leurs composés, et la couche II est formée d'au moins un matériau sélectionné parmi ceux ayant la formule chimique I telle que montrée ci-dessous : 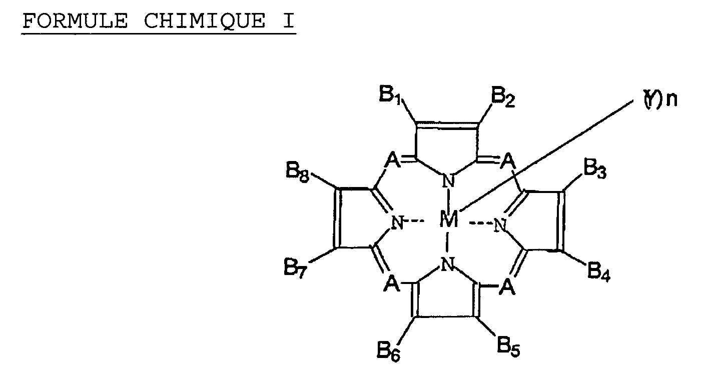 où :
A représente chacun indépendamment -N = ou -C(R) - ;
R est un groupe hydrogène, alkyle, alcoxyle, aralkyle, alkaryle, aryle, ou hétérocyclique ;
M est un élément sélectionné des groupes IA, IIA, IIIA, et IVA, et des troisième, quatrième, cinquième et sixième groupes périodiques dans le tableau périodique ;
Y est un matériau choisi parmi les groupes alcoxyle, phénoxyle, alkylamine, arylamine, alkylphosphine, arylphosphine, alkylsoufre, et arylsoufre, ou un élément sélectionné parmi les groupes VIA et VIIA dans le tableau périodique ;
n est 0, 1 ou 2 ; et,
B (B₁ ~ B₈) représente chacun indépendamment hydrogène, alkyle, aryle, alcoxyle, aryloxyalkyle, hydroxyle, hydroxyalkyle, aralkyle, alkylamino, arylamino, alkylthiol, arylthiol, nitroalkyle, alkylcarbonyle, alcoxycarbonyle, phényle, amine, cyanyle, naphtyle, alkaryle, halogène ou un groupe hétérocyclique, ou deux ou plus parmi eux complètent ensemble un cycle non saturé ou saturé à cinq, six, ou sept chaînons, qui comporte de préférence un ou plusieurs substituants sélectionnés parmi alkyle, aryle, alcoxyle, aryloxyalkyle, hydroxyle, hydroxyalkyle, aralkyle, alkylamino, arylamino, nitroalkyle, alkylcarbonyle, alcoxycarbonyle, phényle, amine, cyanyle, naphtyle, alkaryle, halogène et un groupe hétérocyclique.

2. Dispositif tel que revendiqué dans la revendication 1, dans lequel la couche I a une épaisseur de 0,2 nm à 3 nm, et la couche II a une épaisseur de 0,5 nm à 50 nm.

3. Dispositif tel que revendiqué dans la revendication 1 ou la revendication 2, dans lequel la couche I est formée de Li₂O.

4. Dispositif tel que revendiqué dans l'une quelconque des revendications précédentes, dans lequel la couche II est formée d'au moins un matériau sélectionné parmi ceux ayant les formules chimiques II et III telles que montrées ci-dessous : 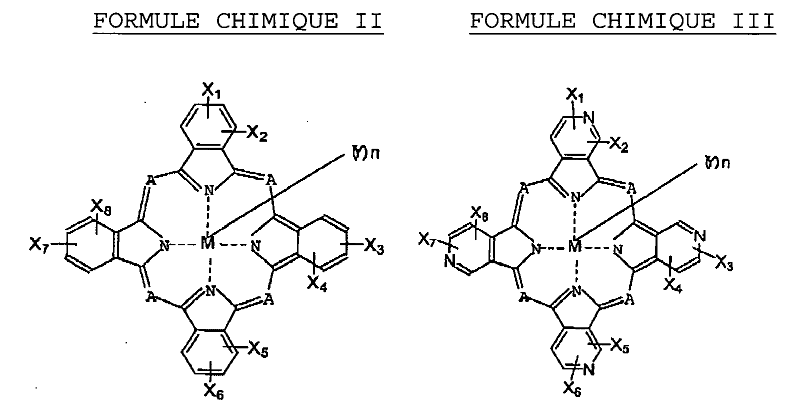 où :
A représente chacun indépendamment -N = ou C(R) = ;
R est hydrogène, alkyle, alcoxyle, aralkyle, alkaryle, aryle, ou un groupe hétérocyclique ;
M est un élément sélectionné parmi les groupes IA, IIA, IIIA, et IVA, et les troisième, quatrième, cinquième et sixième groupes périodiques dans le tableau périodique ;
Y est un matériau sélectionné parmi les groupes alcoxyle, phénoxyle, alkylamine, arylamine, alkylphosphine, arylphosphine, alkylsoufre, et arylsoufre, ou un élément sélectionné parmi les groupes VIA et VIIA dans le tableau périodique ;
n est 0, 1 ou 2 ; et,
X(X₁~ X₈) représente chacun indépendamment hydrogène, alkyle, aryle, alcoxyle, aryloxyalkyle, hydroxyle, hydroxyalkyle, aralkyle, alkylamino, arylamino, alkylthiol, arylthiol, nitroalkyle, alkylcarbonyle, alcoxycarbonyle, phényle, amine, cyanyle, naphtyle, alkaryle, halogène ou un groupe hétérocyclique, ou deux ou plus parmi eux complètent ensemble un cycle non saturé ou saturé à cinq, six, ou sept chaînons, qui comporte de préférence un ou plusieurs substituants sélectionnés parmi alkyle, aryle, alcoxyle, aryloxyalkyle, hydroxyle, hydroxyalkyle, aralkyle, alkylamino, arylamino, nitroalkyle, alkylcarbonyle, alcoxycarbonyle, phényle, amine, cyanyle, naphtyle, alkaryle, halogène et un groupe hétérocyclique.

5. Dispositif tel que revendiqué dans l'une quelconque des revendications précédentes, dans lequel la couche II est formée d'au moins un matériau sélectionné parmi ceux dont les formules chimiques IV et V sont telles que montrées ci-dessous : 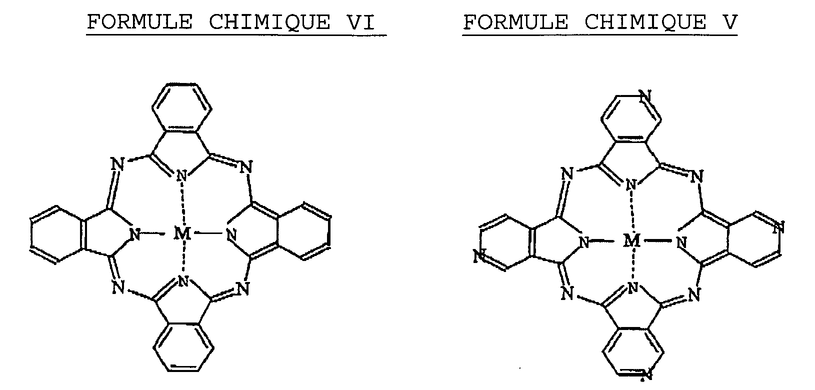 où M est sélectionné parmi Co, AlCl, Cu, 2Li, Fe, Pb, Mg, SiCl₂, 2Na, Sn, Zn, Ni, Mn, VO, 2Ag, MnCl, et SnCl₂.

6. Dispositif organique électroluminescent (EL) comprenant, de manière séquentielle, une première électrode, une multicouche EL, une couche mélangée et une deuxième électrode, dans lequel la couche mélangée comprend un premier matériau et un deuxième matériau, le premier matériau étant sélectionné d'un premier groupe de métaux alcalins, de métaux alcalino-terreux et/ou de leurs composés, et le deuxième matériau étant sélectionné d'un deuxième groupe des matériaux ayant la formule I : 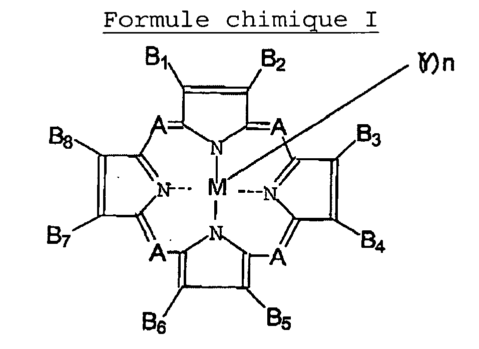 où :
A représente chacun indépendamment -N = ou -C(R) - ;
R est hydrogène, alkyle, alcoxyle, aralkyle, alkaryle, aryle, ou un groupe hétérocyclique ;
M est un élément sélectionné parmi les groupes IA, IIA, IIIA, et IVA, et les troisième, quatrième, cinquième et sixième groupes périodiques dans le tableau périodique ;
Y est un matériau choisi parmi les groupes alcoxyle, phénoxyle, alkylamine, arylamine, alkylphosphine, arylphosphine, alkylsoufre, et arylsoufre, ou un élément sélectionné parmi les groupes VIA et VIIA dans le tableau périodique ;
n est 0, 1 ou 2 ; et,
B(B₁ ~ B₈) représente chacun indépendamment hydrogène, alkyle, aryle, alcoxyle, aryloxyalkyle, hydroxyle, hydroxyalkyle, aralkyle, alkylamino, arylamino, alkylthiol, arylthiol, nitroalkyle, alkylcarbonyle, alcoxycarbonyle, phényle, amine, cyanyle, naphtyle, alkaryle, halogène ou un groupe hétérocyclique, ou deux ou plus parmi eux complètent ensemble un cycle non saturé ou saturé à cinq, six, ou sept chaînons, qui comporte de préférence un ou plusieurs substituants sélectionnés parmi alkyle, aryle, alcoxyle, aryloxyalkyle, hydroxyle, hydroxyalkyle, aralkyle, alkylamino, arylamino, nitroalkyle, alkylcarbonyle, alcoxycarbonyle, phényle, amine, cyanyle, naphtyle, alkaryle, halogène et un groupe hétérocyclique.

7. Dispositif tel que revendiqué dans l'une quelconque des revendications 2, 3 et 6, dans lequel deux ou plus de B(B_{1~} B₈) complètent ensemble un cycle non saturé ou saturé à cinq, six ou sept chaînons formés d'un ou d'une pluralité d'atomes de carbone, de soufre, d'oxygène et/ou d'azote.

8. Dispositif tel que revendiqué dans l'une quelconque des revendications 2, 3, 6 et 7, dans lequel ledit M de la formule chimique I est sélectionné parmi 2Li, 2Na, Mg, Ca, Ti, V, Cr, Mn, Fe, Co, Ni, Pt, Cu, 2Ag, Zn, Pd, Al, Ga, In, Si, Sn, Pb, et 2H.

9. Dispositif tel que revendiqué dans l'une quelconque des revendications 2, 3 ou 6 à 8, dans lequel ledit Y de la formule chimique I est sélectionné parmi oxygène, fluore, chlore, brome, un groupe alcoxyle où les fractions alkyle contiennent environ 1 à 10 atomes de carbone, et un groupe phénoxyle.

10. Dispositif tel que revendiqué dans la revendication 6, dans lequel le rapport de mélange entre lesdits premier et deuxième matériaux est soit fixe ou variable comme une fonction de position dans la direction de l'épaisseur de la couche.

11. Dispositif tel que revendiqué dans l'une quelconque des revendications 6 et 10, dans lequel la couche mélangée a une épaisseur de 0,5 nm à 10 nm.

12. Dispositif tel que revendiqué dans l'une quelconque des revendications précédentes, dans lequel la deuxième électrode est formée en aluminium.

13. Dispositif tel que revendiqué dans l'une quelconque des revendications 6 et 10 à 12, dans lequel le premier matériau du premier groupe est Li₂O.

14. Dispositif tel que revendiqué dans l'une quelconque des revendications 6 et 10 à 13, dans lequel le deuxième matériau est sélectionné de ceux ayant les formules chimiques II et III telles que montrées ci-dessous . 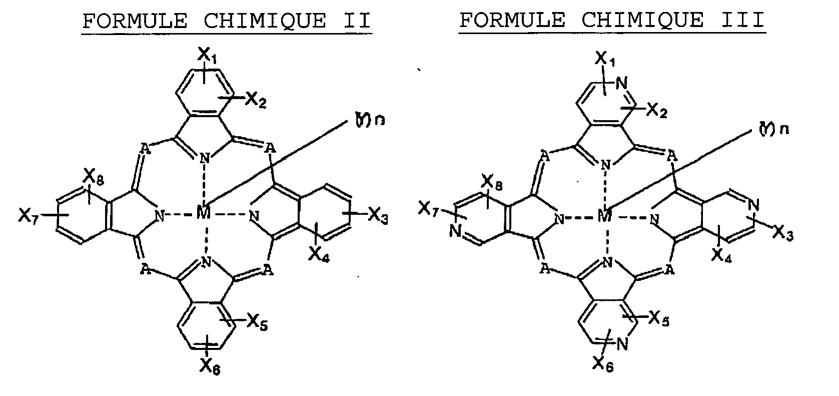 où :
A représente chacun indépendamment -N = ou -C(R) = ;
R est hydrogène, alkyle, alcoxyle, aralkyle, alkaryle, aryle, ou un groupe hétérocyclique ;
M est un élément sélectionné parmi les groupes IA, IIA, IIIA, et IVA, et les troisième, quatrième, cinquième et sixième groupes périodiques dans le tableau périodique ;
Y est un matériau choisi parmi les groupes alcoxyle, phénoxyle, alkylamine, arylamine, alkylphosphine, arylphosphine, alkylsoufre, et arylsoufre, ou un élément sélectionné parmi les groupes VIA et VIIA dans le tableau périodique ;
n est 0, 1 ou 2 ; et,
X(X_{1 ~} X₈) représente chacun indépendamment hydrogène, alkyle, aryle, alcoxyle, aryloxyalkyle, hydroxyle, hydroxyalkyle, aralkyle, alkylamino, arylamino, alkylthiol, arylthiol, nitroalkyle, alkylcarbonyle, alcoxycarbonyle, phényle, amine, cyanyle, naphtyle, alkaryle, halogène ou un groupe hétérocyclique, ou deux ou plus parmi eux complètent ensemble un cycle non saturé ou saturé à cinq, six, ou sept chaînons, qui comporte de préférence un ou plusieurs substituants sélectionnés parmi alkyle, aryle, alcoxyle, aryloxyalkyle, hydroxyle, hydroxyalkyle, aralkyle, alkylamino, arylamino, nitroalkyle, alkylcarbonyle, alkoxycarbonyle, phényle, amine, cyanyle, naphtyle, alkaryle, halogène et un groupe hétérocyclique.

15. Dispositif tel que revendiqué dans la revendication 4 ou la revendication 14, dans lequel ledit M des formules chimiques II et III est sélectionné parmi 2Li, 2Na, Mg, Ca, Ti, V, Cr, Mn, Fe, Co, Ni, Pt, Cu, 2Ag, Zn, Pd, Al, Ga, In, Si, Sn, Pb, et 2H.

16. Dispositif tel que revendiqué dans l'une quelconque des revendications 4, 14 et 15, dans lequel ledit Y des formules chimiques II et III est sélectionné parmi oxygène, fluore, chlore, brome, un groupe alcoxyle où les fractions alkyle contiennent environ de 1 à 10 atomes de carbone, et un groupe phénoxyle.

17. Dispositif tel que revendiqué dans l'une quelconque des revendications 4 et 14 à 16, dans lequel deux ou plus de X(X₁-X₈) complètent ensemble un cycle non saturé ou saturé à cinq, six ou sept chaînons formés d'un ou d'une pluralité d'atomes de carbone, soufre, oxygène et/ou d'azote.

18. Dispositif tel que revendiqué dans l'une quelconque des revendications 14 à 17, dans lequel le deuxième matériau est sélectionné parmi ceux ayant les formules chimiques IV et V telles que montrées ci-dessous : 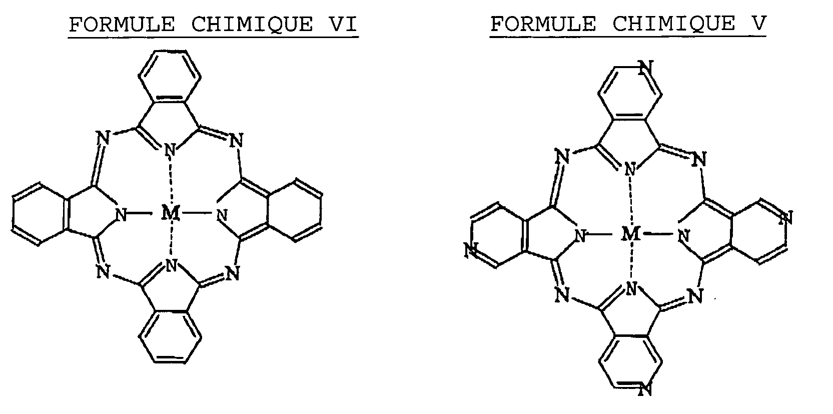 où M est sélectionné parmi Co, AlCl, Cu, 2Li, Fe, Pb, Mg, SiCl₂, 2Na, Sn, Zn, Ni, Mn, VO, 2Ag, MnCl, et SnCl₂.
